# EUROPÄISCHE PATENTSCHRIFT

(11) **EP 0 849 882 B1**
(45) Veröffentlichungstag und Bekanntmachung des Hinweises auf die Patenterteilung: **13.08.2003**
(21) Anmeldenummer: 97121334.3
(22) Anmeldetag: 04.12.1997
(51) Int. Cl.: H03L 7/085

(54) **Verfahren zum Ermitteln einer Ansteuerspannung für einen spannungsgesteuerten Oszillator in einem Phasenregelkreis**
Method for producing a control voltage for a voltage controlled oscillator in a phase locked loop
Procédé de génération d'une tension de commande pour un oscillator commandé par une tension dans une boucle à verrouillage de phase

(30) Priorität: 19.12.1996 DE 19653129
(43) Veröffentlichungstag der Anmeldung: 24.06.1998
(73) Patentinhaber: SIEMENS AKTIENGESELLSCHAFT, 80333 München (DE)
(72) Erfinder: Zwack, Eduard Dipl.-Ing., 82178 Puchheim (DE)

(56) Entgegenhaltungen:
- EP-A- 0 321 725
- DE-A- 2 735 053
- DE-A- 3 540 178
- US-A- 5 459 435

## Beschreibung

Aus der EP 0 321 725 A2 ist ein Phasenregelkreis mit einem spannungsgesteuerten Oszillator bekannt, bei dem die Impulse eines im Oszillator gebildetes Oszillatortaktsignal in einem Zähler kontinuierlich gezählt werden. Die Zählerstände werden gemäß einem von einem Referenztaktsignal abgeleiteten Übernahmesignal in ein Register übernommen und gespeichert. In einer Logikeinheit wird der aktuelle Zählerstand mit dem vorhergehenden Zählerstand verglichen und ein digitales Ansteuersignal ermittelt. Dieses digitale Ansteuersignal gelangt über ein digitales Tiefpaß- und PI-Filter und einen A/D-Wandler an den Spannungssteuereingang des spannungsgesteuerten Oszillators. Die Tiefpaßfilterung bzw. PI-Filterung des digitalen Ansteuersignals sowie die anschließende A/D-Wandlung erfordern einen erheblichen schaltungstechnischen Aufwand.

Die der Erfindung zugrundeliegende Aufgabe besteht darin, den schaltungstechnischen Aufwand unter Berücksichtigung einer digitalen Signalverarbeitung zu verringern. Die Aufgabe wird durch die Merkmale des Anspruchs 1 gelöst.

Der wesentliche Aspekt des erfindungsgemäßen Verfahrens ist darin zu sehen, daß die Zählrichtung eines Vorwärts-Rückwärts-Zählers durch ein gemäß einem Phasenvergleich des Oszillatortakt- und des Referenztaktsignals gebildetes Vergleichssignals derart beeinflußt wird, daß bei jedem durch ein Integrationssignal eingeleiteten Zählvorgang in Abhängigkeit von der aktuell eingestellten Zählrichtung das vorliegende Zählergebnis erhöht oder erniedrigt wird. Das Zählergebnis liegt hierbei an m Zählausgängen des Vorwärts-Rückwärts-Zählers vor. Eine erfindungswesentliche Maßnahme ist darin zu sehen, daß für das Bilden eines pulsdauer- bzw. pulspausenmodulierten Ansteuersignals die n höherwertigen Ausgänge des Vorwärts-Rückwärts-Zählers herangezogen werden. Durch diese Maßnahme wird eine Integration der Vergleichssignale bewirkt, wobei durch die nicht in das Bilden der Ansteuersignale einbezogenen Zählergebnisse der Zählausgänge m-n die Zeitkonstante bzw. die Integrationskonstante des Phasenregelkreises bestimmen - Anpruch 4. Erfindungsgemäß ist die Anzahl der Stufen des die Oszillatortaktsignale zählenden Zählers und die zum Vergleich herangezogene Anzahl von höherwertigen Ausgängen des Vorwärts-Rückwärts-Zählers aufeinander abzustimmen, d.h. die Stufenzahl ist gleich zu wählen. Hierbei werden im Zähler die Impulse des Oszillatortaktsignals kontinuierlich gezählt und bei einem Zählerüberlauf wird der Zähler auf einen Anfangswert - üblicherweise binärer Null-Wert - zurückgesetzt. Jeweils zwischen zwei Zählerüberläufen wird ein pulsdauer- bzw. pulspausenmoduliertes Ansteuersignal mit einer durch die Anzahl der gezählten Periodendauern der Oszillatortaktsignale bestimmten Periodendauer gebildet - Anspruch 4. Dies bedeutet, daß die Zählerstände des Zählers und der höherwertigen Ausgänge des Vorwärts-Rückwärts-Zählers ständig gemäß dem Oszillatortaktsignal verglichen und jeweils ein Impuls mit positivem oder Null-Potential gebildet wird, wobei diese Impulse während eines vollständigen Zählerdurchlaufs des Zählers zu einem pulsdauer- bzw. pulspausenmodulierten Ansteuersignal zusammengefügt werden. Die pulsdauermodulierten Ansteuersignale werden mit Hilfe eines Kondensators und eines Proportionalgliedes - z.B. ein Widerstand - integriert und an einen Steuereingang des spannungsgesteuerten Oszillators des Phasenregelkreises geführt. Das Erhöhen oder Erniedrigen der Zählerstände erfolgt vorteilhaft durch deren inkrementieren oder dekrementieren - Anspruch 3 -, wobei das Inkrementieren und Dekrementieren schaltungstechnisch vorteilhaft durch mehrstufeige Vorwärts-Rückwärts-Zähler-Schaltkreise realisierbar ist.

Weitere vorteilhafte Ausgestaltungen des erfindungsgemäßen Verfahrens insbesondere hinsichtlich einer Aufteilung des Vorwärts-Rückwärts-Zählers in zwei Vorwärts-Rückwärts-Zähler und einer Anordnung zur Durchführung des erfindungsgemäßen Verfahrens sind den weiteren Ansprüchen zu entnehmen.

Im folgenden wird die Erfindung anhand eines Blockschaltbildes näher erläutert. Das Blockschaltbild zeigt eine Phasenvergleichseinrichtung PVE, an deren ersten Eingang E1 ein Referenztaktsignal rts und an deren zweiten Eingang E2 ein in einem spannungsgesteuerten Oszillator VCO - nicht dargestellt - gebildetes Oszillatortaktsignal ts geführt ist. Als Phasenvergleichseinrichtung wird beispielsweise der integrierte CMOS-Schaltkreis HC4046 eingesetzt. In diesem Schaltkreis wird die Phase des Oszillatortaktsignals ts mit der Phase des Referenztaktsignals rts verglichen und bei einem Voreilen des Oszillatortaktsignals ts wird ein positiver und bei einem Nacheilen ein negativer Flankenwechsel bzw. Impuls gebildet und an den Ausgang A geführt, an dem er als Vergleichssignal vs zur Verfügung steht. Alternativ - nicht dargestellt - können aus diesem positiven bzw. negativen Flankenwechsel zwei jeweils positive Impulse abgeleitet werden, die über separate Verbindungen jeweils an einen Vorwärts-Rückwärts-Eingang eines nachgeschalteten ersten Vorwärts-Rückwärts-Zählers VZ1 übermittelt werden. Hierbei zeigt jedes der separaten Signale ein Voreilen oder ein Nacheilen an. Beim Ausführungsbeispiel wird das eine Vergleichssignal vs über den Ausgang A des Phasenvergleichers PVE an einen Vorwärts-Rückwärts-Eingang VRE des ersten Vorwärts-Rückwärts-Zählers VRZ1 geführt. Ein Übernahmeausgang OVA dieses ersten Vorwärts-Rückwärts-Zählers VRZ1 ist mit einem Vorwärts-Rückwärts-Eingang VRE eines zweiten Vorwärts-Rückwärts-Zählers VRZ2 verbunden. Beide Vorwärts-Rückwärts-Zähler VRZ1,2 weisen zusammen m Zählausgänge ZA auf - beispielsweise 20 Zählerausgänge ZA.

Für die Aufteilung der Zählerausgänge ZA bzw. der damit verbundenen Zählstufen zum ersten und zweiten Vorwärts-Rückwärts-Zähler VRZ1,2 ist die vorgesehene Zeitkonstante des Phasenregelkreises bzw. deren Integrationskonstante und die Genauigkeit des zu bildenden pulsdauer- bzw. pulspausenmodulierten Ansteuersignals as zu berücksichtigen. Eine vorteilhafte Aufteilung besteht darin, bei 20 Zahlausgängen ZA den ersten Vorwärts-Rückwärts-Zähler VRZ1 8-stufig (m-n) und den zweiten Vorwärts-Rückwärts-Zähler VRZ2 12-stufig (n) auszugestalten.

Das Oszillatortaktsignal ts wird zusätzlich an eine Dividiereinrichtung DE geführt, in der das Oszillatortaktsignal, das beispielsweise eine Taktfrequenz von 32,384 MHz aufweist, derart dividiert wird, daß ein digitales Integrationssignal is mit einer Taktfrequenz von 8 kHz entsteht. Dieses Integrationssignal is wird über eine entsprechende Verbindung an einen Takteingang TE des ersten Vorwärts-Rückwärts-Zählers VRZ1 geführt. Durch weiteres Dividieren des Integrationssignals is in der Dividiereinrichtung DE wird ein Übernahmetaktsignal ots mit einer Taktgeschwindigkeit erzeugt, die um einen Faktor 2⁸ - d.h. einen Faktor 2^{(m-n)} - niedriger ist als die Taktgeschwindigkeit des Integrationssignals is. Dieses Übernahmetaktsignal ots wird über eine entsprechende Verbindung an einen Takteingang TE des zweiten Vorwärts-Rückwärts-Zählers VRZ2 geführt.

Das Oszillatortaktsignal ts gelangt des weiteren über eine entsprechende Verbindung an einen Takteingang TE eines n-stufigen Zählers Z, der n Zählausgänge ZA aufweist. Die Anzahl n der Zählerausgänge ZA korrespondiert mit der Anzahl n der Zählerausgänge ZA des zweiten Vorwärts-Rückwärts-Zählers VRZ2 - beispielsweise 12 Zählerausgänge ZA. Die Zählerausgänge ZA sowohl des Zählers Z als auch des zweiten Vorwärts-Rückwärts-Zählers VRZ2 sind jeweils auf Vergleichereingänge VE eines Pulsweitenmodulators PWM geschaltet, wobei die Anzahl n der Vergleichereingänge VE auf die Anzahl n der Zählerausgänge ZA abgestimmt ist. Der Pulsweitenmodulator PWM weist einen Ausgang A auf, der mit dem nicht dargestellten spannungsgesteuerten Oszillator VCO des Phasenregelkreises verbunden ist. An diesen Ausgang A ist ein durch einen Kondensator C und einen Widerstand R gebildeter Tiefpaß geschaltet, der die dem Ausgang A vorliegenden pulsdauer- bzw. pulspausenmodulierten Ansteuersignale as integriert bzw. gleichrichtet.

Wie bereits erläutert, wird im Phasenvergleicher PVE das Oszillatortaktsignal ts hinsichtlich seiner Phasenlage mit einem Referenztaktsignal rts verglichen, wobei das am Ausgang A vorliegende Vergleichssignal vs das Voreilen oder das Nacheilen der Phase des Oszillatortaktsignals ts anzeigt. Entsprechend dem angezeigten Voreilen bzw. Nacheilen wird durch das Vergleichssignal vs der erste Vorwärts-Rückwärts-Zähler VRZ1 in eine Vorwärts- oder Rückwärtszählrichtung eingestellt. Dies bedeutet, daß bei einem am Takteingang TE auftretenden Flankenwechsel des Integrationssignals is der Zählerstand des ersten Vorwärts-Rückwärts-Zählers VRZ1 inkrementiert bzw. dekrementiert, d.h. um einen Zählwert 1 erhöht oder erniedrigt wird. Bei einem längeren Vor- oder Nacheilen der Phase des Oszillatortaktsignals ts wird der Zählerstand des ersten Vorwärts-Rückwärts-Zählers VRZ1 derart erhöht oder erniedrigt, daß ein Überlaufsignal ovs am Ausgang des Überlaufausgangs OVA auftritt. Bei Auftreten eines Überlaufsignals ovs wird durch die Flanke des folgenden Übernahmesignals ots der Zählerstand des zweiten Vorwärts-Rückwärts-Zählers VRZ2 inkrementiert oder dekrementiert, d.h. um 1 erhöht oder erniedrigt. Durch dieses Inkrementieren bzw. Dekrementieren wird der Zählerstand an den Zählausgängen ZA entsprechend modifiziert. Beim Ausführungsbeispiel wird beispielsweise bei einer Taktfrequenz des Oszillatortaktsignals ts von 32,384 MHz und einer Taktgeschwindigkeit des Integrationssignals is von 8 kHz der Zählerstand des zweiten Vorwärts-Rückwärts-Zählers VRZ2 im Sekundenrhythmus geändert. Dies bedeutet eine Zeitkonstante des Phasenregelkreises von ca. einer Sekunde. Diese Integrationskonstante wird vorwiegend durch die Anzahl der Stufen des ersten Vorwärts-Rückwärts-Zählers VRZ1 bestimmt. Bei beispielsweise einer 8-stufigen Ausführung, bei der eine Stufe einem binären Zählschritt entspricht, wird ein Überlaufsignal ovs bei einem Zählerstand von 4096 erreicht. Folglich wird eine einseitige Phasenablage - voreilend oder nacheilend - um 4096 Zählschritte verzögert an den zweiten Vorwärts-Rückwärts-Zähler VRZ2 übermittelt, indem durch ein folgendes Inkrementieren oder Dekrementieren dann eine Änderung des Zählerstands und eine damit verbundene Änderung des Pulspausenverhältnisses des pulsdauer- bzw. pulspausenmodulierten Ansteuersignals as erreicht wird.

Der erste und zweite Vorwärts-Rückwärts-Zähler VRZ1,2 kann alternativ durch einen einzigen Vorwärts-Rückwärts-Zähler - nicht dargestellt - realisiert sein. Die dargestellten beiden Vorwärts-Rückwärts-Zähler VRZ1,2 bzw. der nicht dargestellte einzige Vorwärts-Rückwärts-Zähler sind des weiteren mit Einstelleingängen EE ausgestattet, über die ein m-stelliger binärer Einstellwert über entsprechende Schaltmittel - nicht dargestellt - oder eine hierfür vorgesehene Speichereinrichtung - ebenfalls nicht dargestellt - eingegeben werden kann. Diese Eingabe eines Einstellwertes gewährleistet ein Einschwingen des Phasenregelkreises mit einem eine mittlere Pulsdauer bzw. Pulspause aufweisenden Ansteuersignal as.

Bei einem Ausfall der Referenztaktsignale rts soll das vor dem Ausfall ermittelte Ansteuersignal as hinsichtlich seines Pulspausenverhältnisses bis zum Empfang von Referenztaktsignalen rts eingestellt werden. Hierzu können gemäß einer ersten Alternative mittels des Schalters S die Oszillatortaktsignale ts von der Dividiereinrichtung DE geschaltet und ein Zählen in den beiden Vorwärts-Rückwärtszählern VRZ1,2 unterbunden werden. Der Zählerstand an den n Zählerausgängen ZA bleibt bis Empfang weiterer Referenztaktsignale rts unverändert, wobei der Ausfall und der Empfang der Referenztaktsignale rts in dem Phasenvergleicher PVE festgestellt wird - nicht dargestellt. Bei einer weiteren Alternative können die Vergleichssignale vs über eine Tristate-Logikschaltung - durch ein strichliertes Rechteck mit der Bezeichnung TL angedeutet - an den Vorwärts-Rückwärts-Eingang VRE des ersten Vorwärts-Rückwärts-Zählers VRZ1 geführt werden. Bei einem Ausfall des Referenztaktsignals rts werden die Ausgänge der Tristate-Logikschaltung unwirksam, d.h. hochohmig gesteuert. Hierdurch wird in den beiden Vorwärts-Rückwärts-Zählern VRZ1,2 ein Vorwärts- oder Rückwärtszählen unterbunden und der Zählerstand an den n Zählerausgängen ZA bleibt bis Empfang weiterer Referenztaktsignale rts unverändert. Für die Steuerung des Schalters S bzw. der Tristate-Logikschaltung TL ist ihr Steuereingang ST mit einem Steuerausgang SA des Phasenvergleichers SA verbunden.

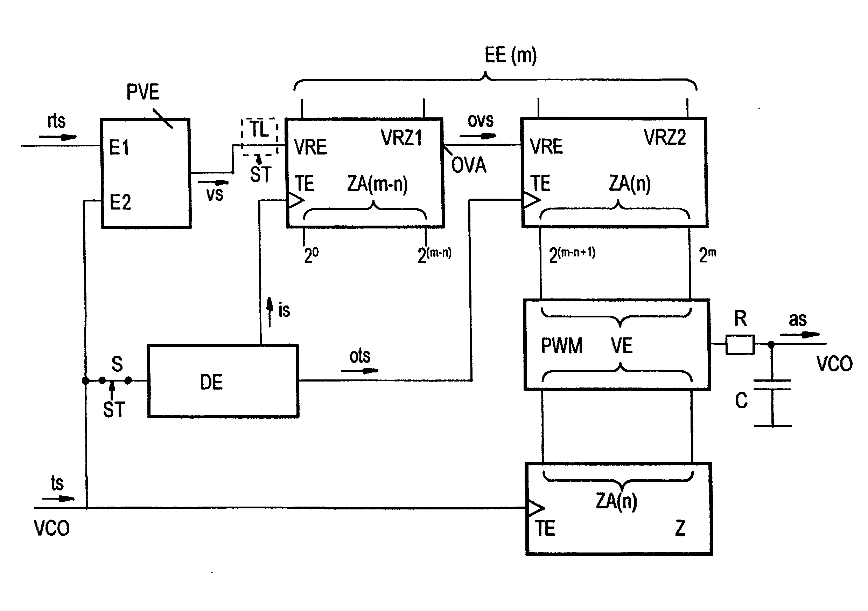

## Patentansprüche

1. Verfahren zum Ermitteln einer Ansteuerspannung (as) für einen spannungsgesteuerten Oszillator (VCO) in einem Phasenregelkreis, bei dem die Phasenlage eines zugeführten Referenztaktsignals (rts) und eines im Oszillator (VCO) gebildeten Oszillatortaktsignals (ts) verglichen wird,
**dadurch gekennzeichnet,**
- **daß** zumindest ein das Vergleichergebnis repräsentierendes Vergleichssignal (vs) gebildet wird,
- **daß** das zumindest eine Vergleichssignal (vs) die Zählrichtung eines m-stufigen Vorwärts-Rückwärts-Zählers (VRZ) beeinflußt, wobei an einen Takteingang (ZE) des Vorwärts-Rückwärts-Zählers (VRZ) ein vom Osillatortaktsignal (ts) abgeleitetes und gegenüber diesem eine reduzierte Taktgeschwindigkeit aufweisendes Integrationssignal (is) geführt ist,
- **daß** bei jedem durch das Integrationssignal (is) eingeleiteten Zählvorgang in Abhängigkeit von der aktuell eingestellten Zählrichtung das vorliegende Zählergebnis erhöht oder erniedrigt wird, wobei an m Zählausgängen das aktuelle Zählergebnis binär vorliegt,
- **daß** Impulse des Oszillatortaktsignals (ts) in einem n (n<m)-stufigen Zähler (Z) kontinuierlich gezählt werden, wobei an n Zählausgängen jeweils das aktuelle Zählergebnis binär vorliegt,
- **daß** die Zählergebisse des Zählers (Z) und die Zählergebnisse der n höherwertigen Zählausgänge (ZA) des Vorwärts-Rückwärts-Zählers (VRZ) oszillatortaktgemäß verglichen und in Abhängigkeit von den Vergleichsergebnissen ein pulsdauer- bzw. ein pulspausenmoduliertes Ansteuersignal (as) gebildet wird.

2. Verfahren nach Anspruch 1, **dadurch gekennzeichnet, daß** bei einer Aufteilung des Vorwärts-Rückwärts-Zählers (VRZ) in einen ersten, (m-n)-stelligen und einen zweiten, n-stelligen Vorwärts-Rückwärts-Zähler (VRZ1,2)
- im ersten Vorwärts-Rückwärts-Zähler (VRZ1) bei jedem durch das Integrationssignal (is) eingeleiteten Zählvorgang in Abhängigkeit von der aktuell eingestellten Zählrichtung das vorliegende Zählergebnis erhöht oder erniedrigt wird, wobei ein Zählerüberlauf durch ein Überlaufsiganal (ovs) an einem Überlaufausgang (OVA) angezeigt wird, und
- im zweiten Vorwärts-Rückwärts-Zähler (VRZ2) bei jedem durch ein Übernahmesignal (ots) eingeleiteten Zählvorgang in Abhängigkeit von dem durch das Überlaufsignal (ovs) beeinflußten Zählrichtung das Zählergebnis erhöht oder erniedrigt wird, wobei das Übernahmesignal (ots) vom Integrationssignal (is) abgeleitet wird und gegenüber diesem eine zumindest um 2^{(m-n)} verminderte Taktgeschwindigkeit aufweist.

3. Verfahren nach Anspruch 1 oder 2, **dadurch gekennzeichnet, daß** das Erhöhen oder Erniedrigen von Zählerständen durch Inkrementieren oder Dekrementieren von Zählerständen bewirkt wird.

4. Verfahren nach einem der Ansprüche 1 bis 3, **dadurch gekennzeichnet, daß** der Zähler (Z) bei einem Zählerüberlauf zurückgesetzt wird, wobei zwischen jeweils zwei Zählerüberläufen ein pulsdauer- bzw. pulspausenmoduliertes Ansteuersignal (as) mit einer durch die Anzahl der gezählten Periodendauern der Oszillatortaktsignale (ts) bestimmten Periodendauer gebildet wird.

5. Verfahren nach einem der Ansprüche 1 bis 4, **dadurch gekennzeichnet, daß** durch die Differenz der m-stelligen und der n-stelligen Zählergebnisse die Zeitkonstante des Phasenregelkreises bestimmbar ist.

6. Anordnung zur Ermitteln einer Ansteuerspannung für einen spannungsgesteuerten Oszillator (VCO) in einem Phasenregelkreis, in dem ein zugeführtes Referenztaktsignal (rts) mit dem Oszillatortaktsignal (ts) verglichen und zumindest ein das Vergleichsergebnis anzeigende Vergleichssignal (vs) gebildet wird,
- mit einem m-stufigen Vor/Rückwärtszähler (VRZ) mit zumindest einem Vorwärts-Rückwärts-Zähleingang (VRE), einen Takteingang (TE) und m, das aktuelle Zählergebnis repräsentierende Zählerausgänge (ZA), wobei an den zumindest einen Vorwärts-Rückwärts-Eingang (VRE) jeweils ein Vergleichssignal (vs) und an den Takteingang (TE) das Integrationssignal (is) geführt ist,
- mit einem n(n<m)-stufigen Zähler (Z) mit einem Takteingang (TE) und n, das aktuelle Zählergebnis repräsentierende Zählerausgängen (ZA), wobei an den Takteingang (TE) das Oszillatortaktsignal (ts) geführt ist,
- mit einem Pulsweitenmodulator (PWM), dessen n Vergleichseingänge (VE) mit den höherwertigen n Zählerausgängen (ZA) des Vorwärts-Rückwärtszählers (VRZ) und dessen weitere Vergleichseingänge (VE) mit den n Zählerausgängen (ZA) des Zählers (Z) verbunden sind, wobei an einem Ausgang (VA) des Pulsweitenmodulators (PWM) ein in diesem gebildetes pulsdauer- bzw. pulspausenmoduliertes Ansteuersignal (as) geführt ist.

7. Anordnung nach Anspruch 6, **dadurch gekennzeichnet, daß** der Vorwärts-Rückwärtszähler (VRZ) durch einen (m-n)-stelligen ersten und einen n-stelligen zweiten Vorwärts-Rückwärts-Zähler (VRZ1,2) gebildet ist, daß ein Überlaufausgang (OVA) des ersten Vorwärts-Rückwärtszählers (VRZ1) mit einem Vorwärts-Rückwärts-Eingang (VRE) des zweiten Vorwärts-Rückwärtszählers (VRZ2) verbunden ist, wobei an einen Takteingang (TE) des ersten Vorwärts-Rückwärtszählers (VRZ1) das Integrationssignal (is) und an zumindest einen Vorwärts-Rückwärts-Eingang (VRE) das zumindest eine Vergleichssignal (vs) und an den Takteingang (TE) des zweiten Vorwärts-Rückwärtszählers (VRZ2) ein vom Integrationssignal (is) abgeleitetes Übernahmesignal (ots) geführt ist.

## Claims

1. Method for determining a drive voltage (as) for a voltage-controlled oscillator (VCO) in a phase-locked loop, in which the phase angle of a supplied reference clock signal (rts) and of an oscillator clock signal (ts) formed in the oscillator (VCO) are compared,
**characterized**
- **in that** at least one comparison signal (vs) representing the comparison result is formed,
- **in that** the at least one comparison signal (vs) influences the counting direction of an m-stage up-down counter (VRZ), an integration signal (is), which is derived from the oscillator clock signal (ts) and has a reduced clock speed relative thereto, being passed to a clock input (ZE) of the up-down counter (VRZ),
- **in that**, in each counting operation initiated by the integration signal (is), the present counting result is increased or decreased depending on the counting direction currently set, the current counting result being present in binary form at m counting outputs,
- **in that** pulses of the oscillator clock signal (ts) are counted continuously in an n(n<m) stage counter (Z), the current counting result in each case being present in binary form at n counting outputs,
- **in that** the counting results of the counter (Z) and the counting results of the n more-significant counting outputs (ZA) of the up-down counter (VRZ) are compared in accordance with the oscillator clock and a pulse-duration- or a pulse-interval-modulated drive signal (as) is formed depending on the comparison results.

2. Method according to Claim 1, **characterized in that**, in the event of the up-down counter (VRZ) being divided into a first, (m-n)-digit and a second, n-digit up-down counter (VRZ1, 2),
- in the first up-down counter (VRZ1), in each counting operation initiated by the integration signal (is), the present counting result is increased or decreased depending on the counting direction currently set, a counter overflow being indicated by an overflow signal (ovs) at an overflow output (OVA), and
- in the second up-down counter (VRZ2), in each counting operation initiated by an acceptance signal (ots), the counting result is increased or decreased depending on the counting direction influenced by the overflow signal (ovs), the acceptance signal (ots) being derived from the integration signal (is) and having a clock speed that is reduced at least by 2^{(m-n)} relative thereto.

3. Method according to Claim 1 or 2, **characterized in that** the increasing or decreasing of counter readings is effected by incrementing or decrementing counter readings.

4. Method according to one of Claims 1 to 3, **characterized in that** the counter (Z) is reset in the event of a counter overflow, a pulse-duration- or pulse-interval-modulated drive signal (as) with a period duration determined by the number of counted period durations of the oscillator clock signals (ts) being formed between in each case two counter overflows.

5. Method according to one of Claims 1 to 4, **characterized in that** the time constant of the phase-locked loop can be determined by the difference between the m-digit and the n-digit counting results.

6. Arrangement for determining a drive voltage for a voltage-controlled oscillator (VCO) in a phase-locked loop, in which a supplied reference clock signal (rts) is compared with the oscillator clock signal (ts) and at least one comparison signal (vs) indicating the comparison result is formed,
- having an m-stage up/down counter (VRZ) having at least one up-down counting input (VRE), a clock input (TE) and m counter outputs (ZA) representing the current counting result, in each case a comparison signal (vs) being passed to the at least one up-down input (VRE) and the integration signal (is) being passed to the clock input (TE),
- having an n(n<m)-stage counter (Z) having a clock input (TE) and n counter outputs (ZA) representing the current counting result, the oscillator clock signal (ts) being passed to the clock input (TE),
- having a pulse width modulator (PWM), whose n comparison inputs (VE) are connected to the more-significant n counter outputs (ZA) of the up-down counter (VRZ) and whose further comparison inputs (VE) are connected to the n counter outputs (ZA) of the counter (Z), a pulse-duration- or pulse-interval-modulated drive signal (as) formed in the pulse width modulator (PWM) being carried at an output (VA) of the said pulse width modulator.

7. Arrangement according to Claim 6, **characterized in that** the up-down counter (VRZ) is formed by an (m-n)-digit first and an n-digit second up-down counter (VRZ1, 2), **in that** an overflow output (OVA) of the first up-down counter (VRZ1) is connected to an up-down input (VRE) of the second up-down counter (VRZ2), the integration signal (is) being passed to a clock input (TE) of the first up-down counter (VRZ1) and the at least one comparison signal (vs) being passed to at least one up-down input (VRE) and an acceptance signal (ots) derived from the integration signal (is) being passed to the clock input (TE) of the second up-down counter (VRZ2).

## Revendications

1. Procédé de détermination d'une tension de commande (as) pour un oscillateur (VCO) commandé par une tension dans une boucle à verrouillage de phase, dans lequel est comparée la relation des phases d'un signal d'horloge de référence amené (rts) et d'un signal d'horloge (ts) de l'oscillateur formé dans l'oscillateur (VCO), **caractérisé**
- **en ce qu'**est formé au moins un signal de comparaison (vs) représentant le résultat de la comparaison,
- **en ce que** ledit au moins un signal de comparaison (vs) influence le sens de comptage d'un compteur / décompteur (VRZ) à m niveaux, un signal d'intégration (is) dérivé du signal d'horloge (ts) de l'oscillateur et ayant une vitesse d'horloge réduite par rapport à ce dernier étant amené à une entrée d'horloge (TE) du compteur / décompteur (VRZ),
- **en ce que** le résultat de comptage obtenu est majoré ou minoré à chaque opération de comptage déclenchée par le signal d'intégration (is) en dépendance du sens de comptage tel qu'actuellement défini par réglage, le résultat de comptage actuel se trouvant au niveau de m sorties de compteur sous forme binaire, et
- **en ce que** des impulsions du signal d'horloge (ts) sont comptées en continu dans un compteur (Z) à n (n<m) niveaux, le résultat de comptage actuel se trouvant à chaque fois au niveau de n sorties de compteurs sous forme binaire
- **en ce que** les résultats de comptage du compteur (Z) et les résultats de comptage des sorties de compteur (ZA) de poids plus fort du compteur/décompteur (VRZ) sont comparés selon l'horloge de l'oscillateur et en ce qu'un signal de commande (as) à modulation de longueur d'impulsion respectivement à modulation de pause d'impulsion est formé en dépendance des résultats de la comparaison.

2. Procédé selon la revendication 1, **caractérisé en ce qu'**en cas de partage du compteur / décompteur (VRZ) en un premier compteur / décompteur à (m - n) positions et en un second compteur / décompteur à n positions (VRZ1, 2)
- le résultat du comptage obtenu est majoré ou minoré, dans le premier compteur/décompteur (VRZ1), à chaque opération de comptage déclenchée par le signal d'intégration (is) en dépendance du sens de comptage tel qu'actuellement réglé, un dépassement de capacité du compteur étant indiqué par un signal de dépassement de capacité (ovs) au niveau d'une sortie de dépassement de capacité (OVA) et
- le résultat du comptage est majoré ou minoré, dans le deuxième compteur/décompteur (VRZ2), à chaque opération de comptage déclenchée par un signal de prise (ots) en dépendance du sens de comptage influencé par le signal de dépassement de capacité (ovs), le signal de prise (ots) étant dérivé du signal d'intégration (is) et ayant, par rapport à ce dernier, une vitesse d'horloge réduite d'au moins 2 ^{(m - n)}.

3. Procédé selon la revendication 1 ou 2, **caractérisé en ce que** la majoration ou la minoration d'états du compteur sont effectuées par incrémentation ou décrémentation d'états du compteur.

4. Procédé selon l'une des revendications 1 à 3, **caractérisé en ce que** le compteur (Z) est remis à une valeur initiale en cas de dépassement de capacité de compteur, un signal de commande (as) à modulation de longueur d'impulsion respectivement à modulation de pause d'impulsion et ayant une durée de période définie par le nombre des durées de période comptées des signaux d'horloge (ts) de l'oscillateur étant chaque fois formé entre deux dépassements de capacité du compteur.

5. Procédé selon l'une des revendications 1 à 4, **caractérisé en ce que** la constante de temps de la boucle à verrouillage de phase est déterminable par la différence entre les résultats de comptage à m positions et à n positions.

6. Dispositif pour déterminer une tension de commande pour un oscillateur (VCO) commandé par une tension dans une boucle à verrouillage de phase, dans lequel un signal d'horloge de référence (rts) amené est comparé au signal d'horloge (ts) de l'oscillateur et au moins un signal de comparaison (vs) indiquant le résultat de la comparaison est formé, comprenant
- un compteur / décompteur (VRZ) à m niveaux avec au moins une entrée compteuse / décompteuse (VRE), une entrée d'horloge (TE) et m sorties de compteur (ZA) représentant le résultat de comptage actuel, un signal de comparaison (vs) étant amené à ladite au moins une entrée compteuse / décompteuse (VRE) et le signal d'intégration (is) étant à chaque fois amené à l'entrée d'horloge (TE),
- un compteur (Z) à n (n<m) niveaux avec une entrée d'horloge (TE) et n sorties de compteur (ZA) représentant le résultat du comptage actuel, le signal d'horloge (ts) de l'oscillateur étant amené à l'entrée d'horloge (TE),
- un modulateur de largeur d'impulsion (PWM), dont les n entrées de comparaison (VE) sont connectées aux n sorties de compteur (ZA) de poids plus fort du compteur / décompteur (VRZ) et dont les autres entrées de comparaison (VE) sont connectées aux n sorties de compteur (ZA) du compteur (Z), un signal de commande (as) à modulation de longueur d'impulsion respectivement à modulation de pause d'impulsion étant amené à une sortie (VA) du modulateur de largeur d'impulsion (PWM) après avoir été formé dans ce dernier.

7. Dispositif selon la revendication 6, **caractérisé en ce que** le compteur / décompteur (VRZ) est formé par un premier compteur / décompteur à (m - n) positions et par un deuxième compteur/décompteur à n positions (VRZ1, 2), **en ce qu'**une sortie de dépassement de capacité (OVA) du premier compteur / décompteur (VRZ1) est connectée à une entrée compteuse / décompteuse (VRE) du deuxième compteur/décompteur (VRZ2), le signal d'intégration (is) étant amené à une entrée d'horloge (TE) du premier compteur/décompteur (VRZ1), ledit au moins un signal de comparaison (vs) étant amené à au moins une entrée compteuse / décompteuse (VRE) et un signal de prise (ots) dérivé du signal d'intégration (is) étant amené à l'entrée d'horloge (TE) du deuxième compteur / décompteur (VRZ2).
